# EUROPÄISCHE PATENTSCHRIFT

(11) **EP 1 050 070 B1**
(45) Veröffentlichungstag und Bekanntmachung des Hinweises auf die Patenterteilung: **19.10.2005**
(21) Anmeldenummer: 99963248.2
(22) Anmeldetag: 16.11.1999
(51) Int. Cl.: H01L 21/00

(54) **BELICHTUNGSANLAGE MIT HALTEEINRICHTUNG FÜR EIN SUBSTRAT**
EXPOSURE APPARATUS WITH HOLDING DEVICE FOR A SUBSTRATE
DISPOSITIF D'EXPOSITION AVEC DISPOSITIF DE POSITIONNEMENT D'UN SUBSTRAT

(30) Priorität: 20.11.1998 DE 19853588
(43) Veröffentlichungstag der Anmeldung: 08.11.2000
(73) Patentinhaber: Leica Microsystems Lithography GmbH, 07745 Jena (DE)
(72) Erfinder: SCHUBERT, Gerhard, D-07747 Jena (DE); KIRSCHSTEIN, Ulf-Carsten, D-07751 Jena-Priessnitz (DE); RISSE, Stefan, D-07749 Jena (DE); HARNISCH, Gerd, D-07749 Jena (DE); KALKOWSKI, Gerhard, D-07743 Jena (DE); GUYENOT, Volker, D-07749 Jena (DE)
(74) Vertreter: Reichert, Werner Franz
(86) Internationale Anmeldenummer: PCT/DE1999/003638
(87) Internationale Veröffentlichungsnummer: WO 2000/031774

(56) Entgegenhaltungen:
- EP-A- 0 486 966
- US-A- 5 644 137

## Beschreibung

Die Erfindung bezieht sich auf eine Einrichtung zum Halten eines Substrates in einer Belichtungsanlage, in der das Substrat auf einem in den Koordinaten X,Y verfahrbaren Tisch aufliegt und zwischen Tischfläche und Substrat maßverkörpernde Mittel zur Abstandseinstellung und zur Ausrichtung des Substrates relativ zu einer Belichtungsoptik vorgesehen sind, aus der eine Korpuskularstrahlung rechtwinklig, der Koordinate Z entsprechend, auf die Substratoberfläche gerichtet ist.

Halteeinrichtungen zur Aufnahme von Substraten, insbesondere von Masken und Wafern während der Belichtung in optischen, darunter auch elektronenoptischen Belichtungsanlagen, sind im Stand der Technik in verschiedenen Ausführungen bekannt. In der Regel sind die Haltesysteme auf einem in zwei Koordinaten X,Y verfahrbarer Tisch angeordnet und verfügen über eine Auflageebene für das Substrat, auf welche dieses vor Beginn des Belichtungsvorganges aufgelegt und auf der es gehalten wird, während der Tisch Schritt für Schritt in Richtung X und/oder Y verschoben und dabei zeitlich nacheinander in die gewünschten Belichtungspositionen gebracht wird. Die Auflageebenen werden meist durch hochebene Auflageflächen, teils auch durch mehrere punktförmige Auflageelementen gebildet.

Die Grundkörper, Tragplatten usw., auf denen Auflageelemente angeordnet oder Auflageflächen ausgebildet sind, sind in der Regel über Maßverkörperung zur Ausrichtung des Substrates in der Koordinate Z mechanisch fest mit dem Tisch verbunden. Die Koordinate Z entspricht dabei der rechtwinklig auf die Substratoberfläche gerichteten Einstrahlungsrichtung des Belichtungsstrahlenganges.

Die Positioniergenauigkeit der Substratoberfläche, die Ausrichtung der Auflageebene, die Ebenheit einer Auflagefläche und nicht zuletzt die Formstabilität aller Teile und Baugruppen des Haltesystems sind von wesentlicher Bedeutung für die Güte und Feinheit der bei der Belichtung angestrebten Struktur. Das um so mehr, je weiter die Bestrebungen der Mikroelektronikindustrie auf die weitere Verringerung der Strukturbreite gerichtet sind.

Deshalb sind durch geeignete Ausführung der Haltesysteme auch unter dem Einfluß von Temperatur- und Druckschwankungen während des Belichtungsprozesses Maßhaltigkeit und Formbeständigkeit zu gewährleisten. Weiterhin ist bei der Gestaltung von Haltesystemen zu beachten, daß die Belichtungsstrahlung nicht durch Magnetfelder beeinflußt wird, die ihren Ursprung in magnetischen Bauteilen oder in Werkstoffen mit magnetischen Partikeln haben. Auch darf die Belichtungsstrahlung nicht ungewollt durch elektrische Aufladungen des Haltesystems abgelenkt werden. Außerdem dürfen mechanische Kräfte, gleich welchen Ursprungs, nicht über Teile bzw. Baugruppen des Haltesystems in das Substrat eingeleitet werden, was Verformungen und damit Ungenauigkeiten zur Folge hätte. Bei alledem sind die Kosten für die Herstellung der Halteeinrichtung in wirtschaftlich vertretbaren Grenzen zu halten.

Unter dem Gesichtspunkt dieser hohen Anforderungen sind die bisher im Stand der Technik verfügbaren Haltesysteme zu bewerten. So ist beispielsweise aus der US-Patentschrift 5,535,090 wie auch aus der Veröffentlichung "Semiconducter International", Sherman, Vol.20, Nr.8, p.319-322, eine Einrichtung zur Aufnahme von Substraten bekannt, die über eine elektrostatische Chuckanordnung verfügt. Chuckanordnungen weisen elektrisch leitfähige Schichten auf, die über Versorgungskontakte mit abschaltbaren elektrischen Potentialen relativ zu den Substraten beaufschlagt werden können. Bei Beaufschlagung bildet sich ein elektrostatisches Feld aus, durch welches das Substrat elektrostatisch auf einer ebenen, über der leitfähigen Schicht angeordneten Isolierschicht gehalten wird. Dabei ist die Größe der Anziehungskraft zwischen Chuckanordnung und Substrat abhängig von der angelegten elektrischen Spannung, von der Flächengröße der leitfähigen Schicht (der sogenannten Chuckelektrode) und von der Dicke der Isolierschicht zwischen der leitfähigen Schicht und dem Substrat.

Bei der vorgenannten Anordnung ist Saphir als Auflagematerial für das Substrat vorgesehen. Dabei ist nicht die gesamte 8 Zoll (1 Zoll = 2.54cm) große Auflagefläche mit Saphir belegt worden, sondern über einer Zwischenschicht aus Niob wurden lediglich mehrere nur 2 Zoll große Saphirscheiben angeordnet, deren Oberflächen die Auflagefläche für das Substrat bilden. Nachteilig hierbei ist das aufwendige Herstellungsverfahren für die mehrteilige Auflagefläche, das zusätzlich zu dem an sich teuren Saphirmaterial hohe Kosten verursacht.

In der US-Patentschrift 5,600,530 ist eine weitere Aufnahmeeinrichtung für Substrate beschrieben, bei der wiederum eine elektrostatische Chuckanordnung vorgesehen ist. Allerdings wird hier als Material für die lsolierschicht Aluminiumoxid verwendet. Zugleich wird ein Verfahren angegeben, durch welches die Aluminiumoxidschicht durch Rückverdünnen auf das zur Positionierung des Substrates notwendige Maß gebracht wird.

Der Einsatz von Aluminiumoxid aber führt nachteiligerweise zu Problemen, die in seinem ungünstigen Temperaturausdehnungskoeffizienten begründet sind. Deshalb erfordert der Einsatz von Aluminiumoxid zwangsläufig Maßnahmen, die diesen Nachteil kompensieren und eine über ein zulässiges Maß hinausgehende Positions- und/oder Formänderung des Substrates bei Temperaturschwankungen verhindern. Die Lösung dieses Problems geht aus der genannten Schrift nicht hervor.

Ein weiterer wesentlicher Nachteil des bekannten Standes der Technik besteht darin, daß die Haltesysteme stets nur für Substrate einer vorgegebenen Größe ausgelegt sind. Zur Anwendung für die Belichtung von einzelnen Substraten oder von Serien von Substraten unterschiedlicher Größen sind die bekannten Haltesysteme nicht oder nur bedingt geeignet, etwa nur unter der Bedingung eines sehr hohen Montage- und Justageaufwandes.

Eine weitere Aufnahmeeinrichtung für Substrate zur Bearbeitung in einer Elekronenstrahlanlage offenbart die US-Patentschrift 5,644,137. Diese Anordnung ist mit Interferometern zur Positionsbestimmung und Positionsüberwachung des Tisches bzw. des Substrates bei der Bewegung in den Koordinaten X,Y ausgestattet. Hier wird eine Stabilisierung der Lage des Substrates relativ zur Belichtungsoptik dadurch erreicht, daß einige Teile der Halteeinrichtung und die Interferometer Spiegel aus Werkstoff mit gleichem Ausdehnungsverhalten gefertigt sind, wodurch sich eine höhere Positioniergenauigkeit in den Richtungen X und Y ergibt. Allerdings sind bei dieser Veröffentlichung die Probleme in Bezug auf die Ausdehnung in der Koordinate Z und der damit verbundenen Ungenauigkeiten nicht gelöst.

Ausgehend davon liegt der Erfindung die Aufgabe zugrunde, eine Halteeinrichtung der vorbeschriebenen Art so weiterzubilden, daß Auflageelemente für das Substrat schnell und unkompliziert gegeneinander austauschbar sind und dabei trotzdem eine hohe Positioniergenauigkeit erzielt wird.

Erfindungsgemäß wird diese Aufgabe durch eine Belichtungsanlage gemäß Anspruch 1 gelöst.

Damit wird vorteilhaft erreicht, daß die zweite, mit der Auflageebene für das Substrat ausgestattete Tragplatte nach Ausschalten der Haltefunktion von der ersten Tragplatte lösbar ist, wodurch auf einfache und unkomplizierte Weise ein Austausch von Tragplatten mit Auflageebenen für Substrate unterschiedlicher Größen untereinander möglich ist. Aufgrund der Parallelausrichtung beider Tragplatten zueinander und der Ausbildung von Bezugsebenen an den beiden Tragplatten bzw. an den Haltevorrichtungen ist auch nach jedem Wechsel eine genaue Belichtungsposition für das Substrat gewährleistet.

In bevorzugten Ausgestaltungen der Erfindung ist vorgesehen, daß die erste Tragplatte über schwingungsdämpfende Elemente mit dem Tisch verbunden ist und daß die schaltbaren Haltevorrichtungen, die zur Halterung der zweiten Tragplatte auf der ersten vorgesehen sind, zugleich als Distanzstücke ausgebildet sind, durch die beide Tragplatten auf einem vorgegebenen Abstand in Richtung der Koordinate Z zueinander gehalten und zwischen den beiden Tragplatten ein Freiraum vorhanden ist, in den beispielhaft eine an einen Roboterarm gekoppelte Hubeinrichtung eingeführt und mit dieser die zweite Tragplatte entnommen bzw. gegen eine zweite Tragplatte mit abweichender Größe der Auflageebene gewechselt werden kann.

Mit der erfindungsgemäßen Anordnung erreicht man vorteilhaft eine Bauweise, bei der den einzelnen Tragplatten verschiedene Bezugsebenen zugeordnet werden können, wodurch zugleich eine wesentliche Voraussetzung dafür geschaffen ist, auf jeder dieser Tragplatten gesondert Haltevorrichtungen bzw. Bauteile anordnen zu können, die spezifischen Anforderungen im Hinblick auf Maßhaltigkeit und Werkstoffeigenschaften unterliegen, so daß auch bei extremen Einflüssen durch Temperatur, Druck oder mechanischen Kräften eine hochgenaue Belichtung des Substrates gewährleistet ist.

So kann in einer bevorzugten Ausgestaltung der Erfindung beispielhaft vorgesehen sein, daß mindestens die zweite Tragplatte, auf der die Auflageebene für das Substrat ausgebildet ist, bezüglich ihrer Materialeigenschaften, ihrer Abmessungen und ihrer Formgestaltung so ausgelegt ist, daß Kräfte, die ihre Ursache beispielsweise in Materialausdehnungen aufgrund von Temperaturänderungen oder in mechanischen Stößen haben und die von einer derartigen Größe sind, daß sie eine Verformung des Substrates über ein zulässiges Maß hinaus bewirken könnten, nicht auf das Substrat übertragen werden. Diesbezüglich ist erfindungsgemäß zur Herstellung der Tragplatten ein so sprödhartes Material vorgesehen, das eine plastische Verformung aufgrund von Krafteinwirkungen nicht zuläßt.

Damit ist mit Sicherheit gewährleistet, daß sich das Substrat weder vor noch während des Belichtungsvorganges in einem Maße verformen kann, das Ungenauigkeiten bei der Belichtung zur Folge hätte.

Die Verbindung der ersten Tragplatte mit dem Tisch kann vorzugsweise durch Abstandselemente erfolgen, die einerseits mechanisch fest mit der Tischoberfläche verbunden sind und andererseits über elastische Zwischenlagen, die beispielsweise aus einem Fluor-Elastomer bestehen, an die zweite Tragplatte gekoppelt sind.

Eine besonders bevorzugte Ausgestaltungsvariante der Erfindung sieht vor, daß als Haltevorrichtungen zwischen den beiden Tragplatten elektrostatische Chuckanordnungen vorgesehen sind. Diese bestehen jeweils aus einem aus elektrisch nichtleitendem Material gefertigten Grundkörper, auf den eine elektrisch leitende Schicht, beispielsweise aus Nickel oder Chrom, und über dieser wiederum eine Isolierschicht angeordnet ist. Die elektrisch leitende Schicht kann im Hinblick auf ihre flächige Ausdehnung vorteilhaft in einzelne Segmente gegliedert sein, wobei jedes Segment separat an ein elektrisches Potential anschließbar ist.

Dabei sind die der Belichtungsoptik zugewandten Flächen der Isolierschicht als Auflageflächen für die zweite Tragplatte ausgebildet. Diese Chuckanordnungen haben so neben der Haltefunktion für die zweite Tragplatte auch noch die Funktion, eine Bezugsebene zur Ausrichtung der zweiten Tragplatte und damit des Substrates zu bilden, das wie dargestellt auf der zweiten Tragplatte angeordnet ist.

In einer bevorzugten Ausgestaltung der erfindungsgemäßen Halteeinrichtung ist die Auflageebene für das Substrat aus drei Kugeln gebildet, die beispielhaft durch Käfige auf der zweiten Tragplatte gehalten werden oder die auf die zweite Tragplatte aufgeklebt sind. Die Kugeln können radialsymmetrisch, eine Dreipunktauflage für das Substrat bildend, auf einem Teilkreis angeordnet sein. Alternativ hierzu kann jedoch auch vorgesehen sein, daß auf der zweiten Tragplatte (zusätzlich zu den Chuckanordnungen, die zum Halten der zweiten Tragplatte dienen) eine oder mehrere elektrostatische Chuckanordnungen angeordnet sind, an denen eine Auflageebene für das Substrat ausgebildet ist und deren Aufgabe es ist, das Substrat auf der zweiten Tragplatte elektrostatisch zu halten. Dabei ist der Grundkörper dieser Chuckanordnung, beispielsweise durch Ansprengen oder Kleben, auf der zweiten Tragplatte befestigt.

Bei allen Chuckanordnungen ist die elektrisch leitfähige Schicht mit Kontakten versehen. Zur Erzeugung der elektrostatischen Kräfte wird ein elektrisches Potential einerseits an die jeweilige elektrisch leitfähige Schicht der betreffenden Chuckanordnung und andererseits an die auf die Isolierschicht aufgelegte Baugruppe (die zweite Tragplatte) bzw. an das aufgelegte Teil (Substrat) gelegt.

Eine besonders bevorzugte Ausgestaltung der Erfindung sieht vor, daß die zweite Tragplatte und ebenso die Grundkörper und Isolierschichten der Chuckanordnungen aus einer magnetfreien Glaskeramik mit einem Temperaturausdehnungskoeffizienten α_{T} = 0±0,05 × 10⁻⁶ K⁻¹ und einem Elastizitätsmodul von E ≈ 90,6 GPa hergestellt sind. Eine solche Glaskeramik ist unter der Bezeichnung "ZERODUR" im Handel erhältlich.

Die Verwendung dieses Materials ermöglicht einen Aufbau, der extrem unempfindlich gegenüber Temperaturschwankungen ist. Temperatureinflüsse innerhalb der Belichtungsanordnung sind während des Belichtungsvorganges kaum zu vermeiden, sie können aus Wärmeleitung und/oder Wärmestrahlung innerhalb des Systemes herrühren aber auch durch die Belichtung des Substrates eingetragen werden. Mit dem vorgeschlagenen Aufbau lassen sich die negativen Folgen von störenden Temperatureinflüssen jedoch so weit reduzieren, daß der Aufwand für die Temperaturstabilisierung innerhalb der Belichtungsanordnung bzw. in der Nähe des Substrates auf ein Mindestmaß reduziert werden kann.

Ein weiterer Vorteil besteht darin, daß die verwendete Glaskeramik durch konventionelle Optikbearbeitungstechnologien effektiv und bei höchster Maßhaltigkeit bearbeitet werden kann. Das betrifft insbesondere die Herstellung der planen Flächen, aber auch die Einhaltung von Parallelitäten und Winkeln. Damit ist es möglich, Fertigungtoleranzen im Mikrometerbereich und im Bereich von Bogensekunden einzuhalten. Aufgrund der Sprödhärte der Glaskeramik sind plastische Verformungen an den Planflächen ausgeschlossen. Damit wird, wie weiter oben bereits beschrieben, eine unkontrollierte Substratverformung vermieden.

Ein weiterer wesentlicher Vorteil besteht darin, daß mit herkömmlichen Technologien Beschichtungen auf die aus Glaskeramik gefertigten Teile aufgebracht werden können. Derartige Beschichtungen können Spiegelschichten sein, beispielsweise für Interferometerspiegel, oder auch elektrisch leitfähige Schichten, die zum Anlegen eines elektrischen Potentials dienen. Letzteres dient dazu, elektrostatische Aufladungen an unerwünschten Stellen zu vermeiden, die ansonsten beispielsweise auftreten können, wenn während der Belichtung elektrisch geladene Teilchen auf isolierende Oberflächen treffen. An diese Schicht kann auch das elektrische Potential zur Erzeugung der elektrostatischen Chuck-Haltekräfte zwischen erster und zweiter Tragplatte gelegt werden.

Da die verwendete Glaskeramik magnetfrei ist, ist dadurch sichergestellt, daß der Belichtungsstrahlengang nicht durch Magnetfelder beeinflußt werden kann, die ihren Ursprung in Bauteilen aus metallischen bzw. mit Magnetpartikeln versetzten Werkstoffen haben können.

Zur Erzeugung der elektrostatischen Kräfte ist ein elektrisches Potential von bis zu 5000 V vorgesehen. Das Potential ist schaltbar, wodurch die Haltekräfte je nach Bedarf ein- und ausschaltbar sind.

In einer sehr bevorzugten Ausgestaltung der Erfindung ist vorgesehen, daß auf der ersten Tragplatte drei jeweils mit zylindrischem Grundkörper ausgeführte Chuckanordnungen befestigt sind, die gemeinsam eine Auflagefläche für die zweite Tragplatte bilden. Die Chuckanordnungen können beispielhaft auf einem Teilkreis radialsymmetrisch zueinander positioniert sein. Ihre Abmessungen in Richtung der Koordinate Z und ihre Abstände zueinander in den Koordinaten X,Y sind so ausgeführt, daß zwischen den Chuckanordnungen und zwischen erster und zweiter Tragplatte genügend Freiraum bleibt, ein mit einem Roboterarm verbundenes Hebewerkzeug einzuführen und mit diesem die zweite Tragplatte zu untergreifen, von der Auflagefläche abzuheben, aus der Belichtungseinrichtung zu entnehmen und gegen eine Tragplatte auszutauschen, die zur Aufnahme eines Substrates abweichender Größe ausgebildet ist.

Die beschriebene Halteeinrichtung für das Substrat kann weiterhin mit einem Metrologiesystem ausgestattet sein, das zur Bestimmung und Überwachung der Position des Substrates in den Koordinaten X,Y während der Belichtung dient und bei dem zwei orthogonal zueinander ausgerichtete Spiegel vorgesehen sind, die als Referenz für eine interferometrische Meßanordnung dienen.

Die beiden Spiegel können entweder unmittelbar auf die erste Tragplatte aufgesetzt oder auf Zwischenriegel aufgesetzt sein, die mit der ersten Tragplatte verbunden sind. Bei Letzterem dienen die Zwischenriegel als Distanzstücke zur Einstellung der Positionen der Spiegel in Richtung der Koordinate Z.

Auch hierbei kann die Verbindung zwischen Tragplatte, Zwischenriegel und Grundkörper der Spiegel durch Ansprengen oder Kleben erfolgen. Ebenso ist es vorteilhaft, wenn die Spiegel aus derselben Glaskeramik wie vorgenannt hergestellt sind, so daß sich ein einheitliches Ausdehnungsverhalten der betreffenden Teile bzw. Baugruppen bei Temperatureinfluß ergibt. Zur Realisierung der Spiegelflächen können auf die Grundkörpern der Spiegel Beschichtungen mit hohem Reflexionsgrad aufgebracht sein, beispielsweise aus Aluminium mit Oxidschutzschicht.

Selbstverständlich ist bezüglich der Spiegel auch eine Ausgestaltungsvariante denkbar, bei welcher die orthogonal zueinander ausgerichteten Spiegel in L-Form einstückig ausgeführt und ebenfalls entweder direkt auf der ersten Tragplatte oder über Zwischenriegel auf dieser befestigt sind.

Die Erfindung soll nachfolgend anhand eines Ausführungsbeispieles näher beschrieben werden. In den zugehörigen Zeichnungen zeigen
- Fig. 1: den prinzipiellen Aufbau der erfindungsgemäßen Anordnung mit einer Dreipunktauflage für das Substrat,
- Fig. 2: eine Draufsicht aus Fig. 1,
- Fig. 3: den prinzipiellen Aufbau der erfindungsgemäßen Anordnung mit einer elektrostatischen Chuckanordnung zur Aufnahme des Substrates,
- Fig. 4: eine Draufsicht aus Fig. 3,
- Fig. 5: den prinzipiellen Aufbau einer elektrostatischen Chuckanordnung

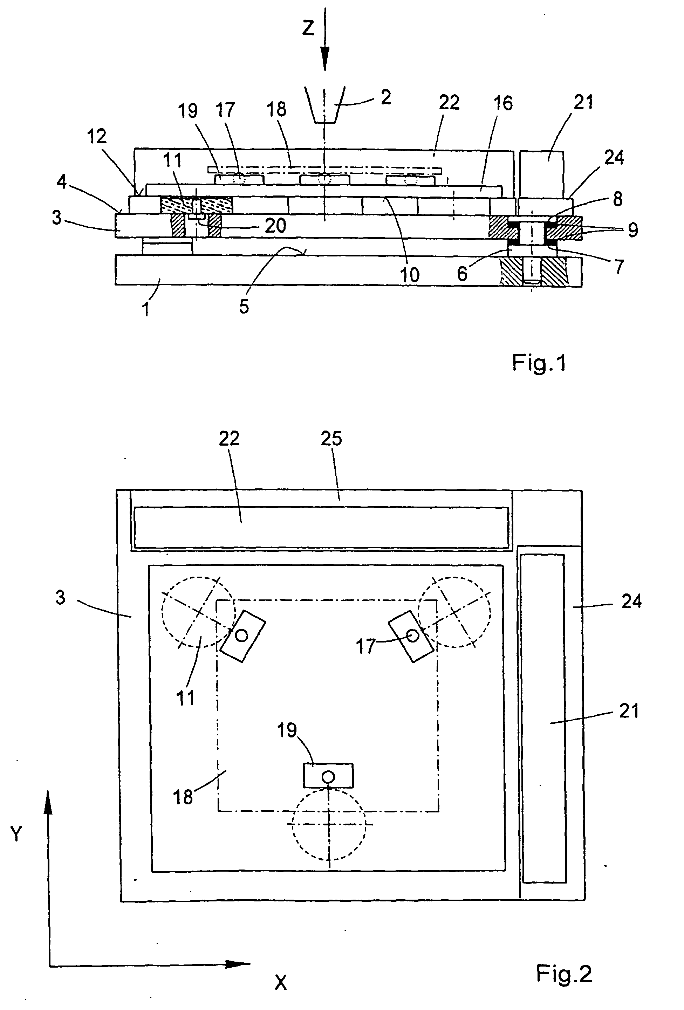

In Fig. 1 ist ein Tisch 1 dargestellt, der in den Koordinaten X,Y relativ zu einer Belichtungsoptik 2 verfahrbar ist. Bei der Belichtungsoptik 2 handelt es sich beispielhaft um eine elektronenoptische Belichtungsanlage, von der die Belichtungsstrahlung rechtwinklig, der Koordinate Z folgend, auf den Tisch gerichtet ist.

Auf dem Tisch 1 ist in Richtung zur Belichtungsoptik 2 zunächst eine erste Tragplatte 3 angeordnet. Die Fläche der Tragplatte 3, die der Belichtungsoptik 2 zugewandt ist, ist als eine erste Bezugsebene 4 vorgesehen. Zu diesem Zweck ist diese Fläche hocheben ausgeführt und zu der von den Koordinaten X,Y aufgespannten Ebene exakt parallel ausgerichtet.

Die Tragplatte 3 ist über Befestigungselemente 6, die beispielhaft auf der Tischfläche 5 mit dem Tisch 1 verpreßt oder verschraubt sein können, mechanisch mit dem Tisch 1 verbunden. Die Verbindung zwischen den Befestigungselementen 6 und der Tragplatte 3 ist so ausgeführt, daß miteinander korrespondierende ringförmige Verbreiterungen 7,8 an den Befestigungselementen 6 wie auch an der Tragplatte 3 einander gegenüber stehen. Dabei sind zwischen den sich gegenüberstehenden ringförmigen Verbreiterungen 7,8 Dämpfungselemente 9 aus einem Fluor-Elastomer angeordnet, deren Aufgabe es ist, die Übertragung von Schwingungen, Stößen oder/oder Verformungen vom Tisch 1 auf die Tragplatte 3 zu reduzieren bzw. zu verhindern.

Auf der Bezugsebene 4 sind drei elektrostatische Chuckanordnungen 11 angeordnet, die eine kreisrunde Querschnittsfläche aufweisen. Die der Belichtungsoptik 2 zugewandten Flächen der drei Chuckanordnungen 11 bilden gemeinsam eine zweite Bezugsebene 12 und zugleich eine Auflageebene für eine zweite Tragplatte 16.

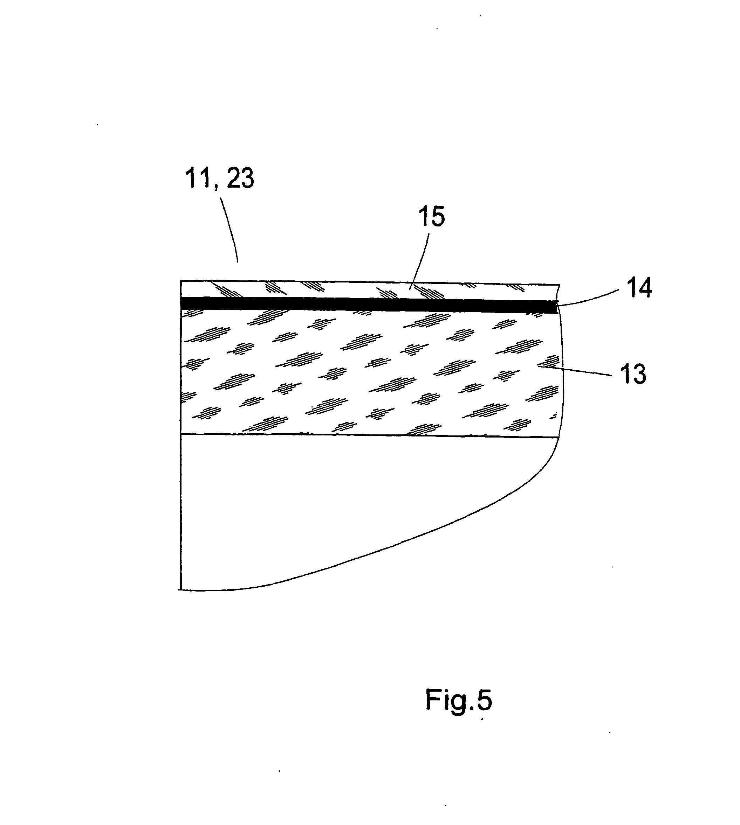

Jede der Chuckanordnungen 11 weist, wie in Fig. 5 dargestellt, einen Grundkörper 13 auf, auf den in Richtung zur Belichtungsoptik 2 eine elektrisch leitfähige Schicht 14 aus Chrom oder Nickel und darüber eine Isolierschicht 15 aufgebracht ist. Die elektrisch leitfähige Schicht 14 kann dabei in Form von mehreren, voneinander elektrisch getrennten Segmenten aufgetragen sein, so daß an die einzelnen Segmente unterschiedliche elektrische Potentiale gelegt werden können.

Gemäß einer bevorzugten Ausgestaltung der Erfindung sind die Grundkörper 13 wie auch die Isolierschichten 15 der Chuckanordnungen 11 aus einer Glaskeramik gleicher Eigenschaften hergestellt, wodurch Unterschiede im Ausdehnungsverhalten auf ein Minimum beschränkt werden bzw. die Genauigkeit der Bezugsebene 12 auch bei Temperatureinfluß erhalten bleibt. Vorteilhaft ist hier die bereits beschriebene Glaskeramik "ZERODUR" vorgesehen.

Auf der Oberseite der Tragplatte 16, d.h. auf der Fläche, die der Belichtungsoptik 2 zugewandt ist, sind drei Kugeln 17, eine Dreipunktauflage bildend, als Auflageelemente für das Substrat 18 angeordnet. Die Kugeln 17 werden durch Käfige 19, die auf die Tragplatte 16 aufgeklebt sind (vgl. Fig. 2), in ihrer Position gehalten.

Die Tragplatte 16 und die Kugeln 17 sind vorteilhaft aus der gleichen Glaskeramik gefertigt wie die Grundkörper 13 und die Isolierschichten 15. Damit sind die Bauteile, die der Maßverkörperung in der Koordinate Z über der ersten Bezugsebene 4 dienen, aus demselben Material gefertigt.

Insofern ergeben sich hier nicht nur die Vorteile im Hinblick auf das Temperaturausdehnungsverhalten, wodurch Temperaturschwankungen weitestgehend kompensiert werden, sondern auch dadurch, daß die Glaskeramik magnetfrei ist und insofern der Belichtungsstrahlengang nicht durch Magnetfelder beeinflußt werden kann, die ihren Ursprung im verwendeten Werkstoff haben. Außerdem entstehen in der Glaskeramik keine Wirbelströme, die über ein damit einhergehendes Magnetfeld den Belichtungsstrahlengang ungewollt beeinflussen könnten.

Die Tragplatte 16 ist mit einer Schicht 10 aus einem elektrisch leitfähigen Material versehen. Wird nun an die Schicht 10 einerseits und an die leitfähigen Schichten 14 der Chuckanordnungen 11 andererseits ein elektrisches Potential von beispielhaft 3000 V gelegt, werden elektrostatische Kräfte erzeugt, durch die die Tragplatte 16 in der in Fig. 1 gezeichneten Position auf der Tragplatte 3 gehalten wird.

Zur Kontaktierung der elektrisch leitfähigen Schichten 14 sind jeweils durch die Grundkörper 13 der Chuckanordnungen 11 hindurch elektrische Anschlüsse 20 geführt. Das Potential ist mittels eines Schalters (nicht dargestellt) ein- bzw. ausschaltbar, so daß nach Spannungsfreischaltung die elektrostatischen Kräfte aufgehoben sind und die Tragplatte 16 gemeinsam mit den Auflageelementen für das Substrat 18 von den Chuckanordnungen 11 abgenommen werden kann. Damit ist jederzeit ein Auswechseln der Tragplatten 16 möglich und Tragplatten für Substrate unterschiedlicher Größen können auf einfache Weise gegeneinander ausgewechselt werden.

Beispielhaft sind weiterhin auf der Tragplatte 3 zwei Spiegel 21 und 22 vorgesehen, von denen jeder über einen Zwischenriegel 24 bzw. 25 auf Abstand zur Bezugsebene 12 gesetzt ist. Die Spiegel 21 und 22 dienen als Referenzspiegel für ein Lasermeßsystem, das hier nicht weiter beschrieben ist. Dabei ist jeweils einer der Spiegel 21, 22 einer der Koordinaten X,Y zugeordnet; sie sind demzufolge orthogonal zueinander ausgerichtet. Sie bestehen aus einem aus Glaskeramik gefertigten Grundkörper, der in Meßrichtung mit einer hoch reflektierenden Schicht, beispielsweise aus Aluminium mit Oxidschicht, versehen ist.

Mit dem Lasermeßsystem ist es möglich, die Position des Tisches 1 und damit die Position des Substrates 18 in den Koordinaten X,Y während der Belichtung zu ermitteln und nach jeder Verschiebung des Tisches 1 in die nächste Belichtungsposition zu kontrollieren und gegebenenfalls zu korrigieren.

Fig. 2 zeigt eine Draufsicht auf die Anordnung nach Fig. 1. Hier sind die orthogonale Ausrichtung der beiden Spiegel 21 und 22 zu erkennen wie auch die Positionen der Chuckanordnungen 11 und der Kugeln 17, auf die das Substrat 18 aufgelegt ist.

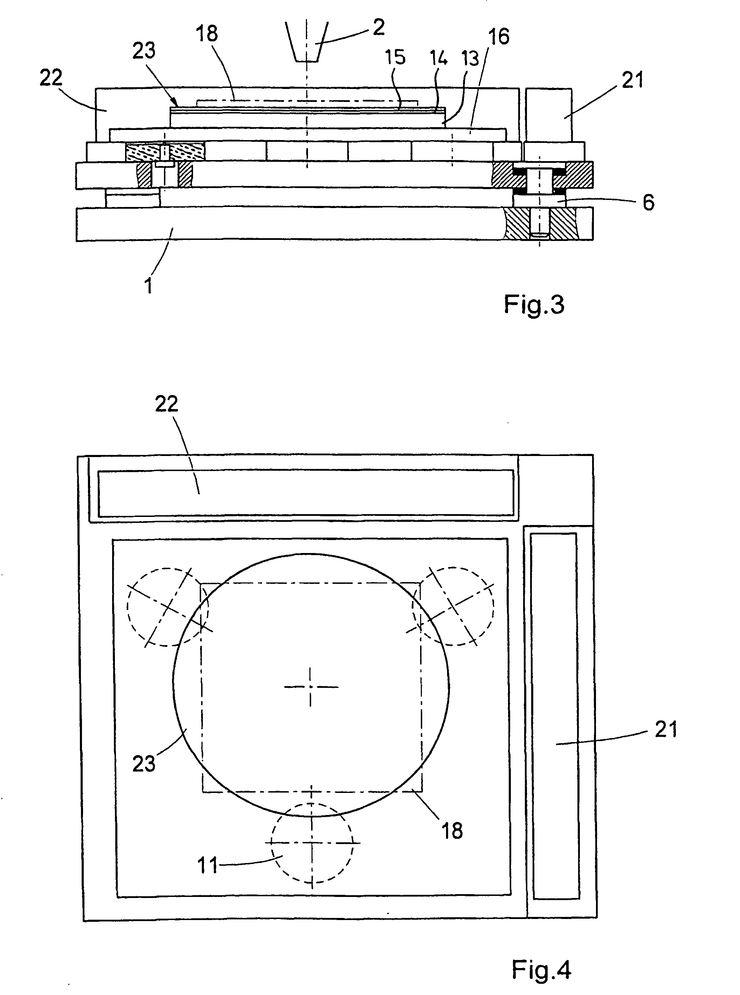

In einer weiteren Ausgestaltungsvariante der Erfindung, die in Fig. 3 beispielhaft dargestellt ist, ist der Aufbau über dem Tisch 1 in Richtung zur Belichtungsoptik 2 bis zur Tragplatte 16 ebenso wie in dem vorher erläuterten Beispiel vorgesehen. Allerdings ist hier für das Substrat 18 keine durch Kugeln gebildete Dreipunktauflage vorhanden, wie das bei der Ausgestaltungsvariante nach Fig. 1 der Fall ist, sondern an deren Stelle eine weitere elektrostatische Chuckanordnung 23.

Die Chuckanordnung 23 ist ebenso wie die Chuckanordnungen 11 gemäß Fig. 5 aufgebaut. Das heißt auf einem Grundkörper 13 ist eine elektrisch leitende Schicht 14 aufgebracht und über dieser eine Isolierschicht 15. Die Isolierschicht 15 ist hocheben ausgeführt, so daß auf ihr das Substrat 18 abgelegt werden kann und dort formgerecht gehalten wird. Analog werden hier die elektrostatischen Haltekräfte dadurch erzeugt, daß an die elektrisch leitfähige Schicht 14 einerseits und an das Substrat 18 andererseits ein elektrisches Potential angelegt wird. Dieses Potential ist ebenfalls schaltbar, so daß mit dem Zu- bzw. Abschalten das Substrat gehalten oder von der Chuckanordnung 23 gelöst werden kann.

Die elektrostatische Anziehungskraft ist dabei abhängig von der Größe der Spannung, der Flächengröße der Chuckanordnung 23 und von der Dicke der Isolierschicht 15. Um das Substrat 18 leicht von der Chuckoberfläche bzw. von der Oberseite der Isolierschicht 15 abnehmen zu können, ist es vorteilhaft, wenn die Außenfläche bzw. Auflagefläche der Isolierschicht 15 in einem Oberflächenprofil einer Tiefe im µm-Bereich ausgeführt ist, so daß das Substrat von der Isolierschicht 15 nach Potentialfreischaltung leicht abnehmbar ist.

In Fig. 4 ist zu erkennen, daß die Chuckanordnung 23 kreisrund ausgeführt und in ihrem Durchmesser etwa den Abmessungen des Substrates 18 angepaßt ist. Hier ist auch wieder die Positionierung der Chuckanordnungen 11 zu erkennen, durch welche die Tragplatte 16 gehalten wird.

Schließlich ist in einer Ausgestaltungsvariante der Erfindung vorgesehen, daß die aus Glaskeramik gefertigten Bauteile an ihrer Oberfläche zumindest an den Oberflächenabschnitten, die hinsichtlich einer Maßverkörperung in Richtung der Koordinate Z keine Funktion haben, mit einer elektrisch leitenden Beschichtung versehen sind. Auf diese Weise wird das elektrostatische Aufladen von Bauteilen an unerwünschten Stellen und damit eine Beeinflussung des Belichtungsstrahlenganges, die Ungenauigkeiten bei der Belichtung zur Folge hätte, vermieden.

### Bezugszeichenliste

- 1: Tisch
- 2: Belichtungsoptik
- 3: erste Tragplatte
- 4: erste Bezugsebene
- 5: Tischfläche
- 6: Befestigungselemente
- 7: Verbreiterung
- 8: Verbreiterung
- 9: Dämpfungselemente
- 10: elektrisch leitfähige Schicht
- 11: Chuckanordnungen
- 12: zweite Bezugsebene
- 13: Grundkörper
- 14: elektrisch leitfähige Schicht
- 15: Isolierschicht
- 16: zweite Tragplatte
- 17: Kugeln
- 18: Substrat
- 19: Käfige
- 20: elektrische Anschlüsse
- 21, 22: Langspiegel
- 23: Chuckanordnung
- 24, 25: Zwischenriegel

## Patentansprüche

1. Belichtungsanlage mit einer Einrichtung zum Halten eines Substrates (18), **gekennzeichnet durch**:
- einen in den Koordinaten X,Y verfahrbaren Tisch (1),
- eine Belichtungsoptik (2), aus der eine Korpuskularstrahlung rechtwinklig, der Koordinate Z entsprechend, auf die Substratoberfläche gerichtet ist,
- ein maßverkörperndes Mittel zur Abstandseinstellung zwischen Tischfläche (5) und Substrat (18) und zur Ausrichtung des Substrates (18) relativ zur Belichtungsoptik,
- zwei parallel zur Ebene X,Y ausgerichtete Tragplatten (3,16), die auf dem Tisch (1) in Richtung zur Belichtungsoptik (2) und in unterschiedlichen Abständen zur Tischfläche (5) vorgesehen sind, von denen eine erste Tragplatte (3) unmittelbar mit dem Tisch (1) verbunden ist, wobei
- die zweite Tragplatte (16) mit der ersten Tragplatte (3) über eine Haltevorrichtung mit aus- und einschaltbarer Haltefunktion, in Verbindung steht, und wobei auf der der Belichtungsoptik (2) zugewandten Seite der zweiten Tragplatte (16) eine Auflageebene für das Substrat (18) ausgebildet ist.

2. Einrichtung nach Anspruch 1, **dadurch gekennzeichnet, dass** als Haltevorrichtung auf der ersten Tragplatte (3) mindestens eine elektrostatische Chuckanordnung (11) vorgesehen ist, die einen auf der ersten Tragplatte (3) befestigten Grundkörper (13), eine die Auflageebene für die zweite Tragplatte (16) bildende Isolierschicht (15) und eine zwischen dem Grundkörper (13) und der Isolierschicht (15) angeordnete elektrisch leitfähige Schicht (14) aufweist.

3. Einrichtung nach Anspruch 2, **dadurch gekennzeichnet, dass** die mindestens eine elektrostatische Chuckanordnung (11) als Distanzstück ausgebildet ist, durch das beide Tragplatten (3,16) in einem vorgegebenen Abstand in Richtung der Koordinate Z zueinander positioniert sind.

4. Einrichtung nach einem der vorgenannten Ansprüche, **dadurch gekennzeichnet, dass** die erste Tragplatte (3) über schwingungsdämpfende Elemente (6) mit dem Tisch (1) verbunden ist.

5. Einrichtung nach einem der vorgenannten Ansprüche, **dadurch gekennzeichnet, dass** die an der zweiten Tragplatte (16) vorgesehene Auflageebene für das Substrat (18) durch drei in Käfigen (19) lagefixierte Kugeln (17) gebildet ist.

6. Einrichtung nach einem der Ansprüche 1 bis 4, **dadurch gekennzeichnet, dass** auf der der Belichtungsoptik zugewandten Fläche der zweiten Tragplatte (16) mindestens eine elektrostatische Chuckanordnung (23) vorgesehen ist, die einen auf der Tragplatte (16) befestigten Grundkörper (13), eine die Auflageebene für das Substrat (18) bildende Isolierschicht (15) und eine zwischen dem Grundkörper (13) und der Isolierschicht (15) angeordnete elektrisch leitfähige Schicht (14) aufweist.

7. Einrichtung nach einem der vorgenannten Ansprüche, **dadurch gekennzeichnet, dass** die zweite Tragplatte (16), die Grundkörper (13) und Isolierschichten (15) der Chuckanordnungen (11, 23) und die Kugeln (17) aus einer Glaskeramik mit einem Temperaturausdehnungskoeffizienten α_{*T*} = 0 ± 0,05 × 10⁻⁶*K*⁻¹ und einem Elastizitätsmodul von E = 90,6 GPa hergestellt sind.

8. Einrichtung nach einem der vorgenannten Ansprüche, **dadurch gekennzeichnet, dass** auf der ersten Tragplatte (3) drei zylindrisch ausgeführte elektrostatische Chuckanordnungen (11) vorgesehen und auf einem Teilkreis radialsymmetrisch angeordnet sind.

9. Einrichtung nach einem der vorgenannten Ansprüche, **dadurch gekennzeichnet, dass** zwei orthogonal zueinander ausgerichtete Spiegel (21,22) zur Bestimmung und Überwachung der Position des Substrates bezüglich der Koordinaten X,Y vorgesehen sind.

10. Einrichtung nach Anspruch 9, **dadurch gekennzeichnet, dass** die Spiegel (21,22) Grundkörper aufweisen, die ebenfalls aus der Glaskeramik wie in Anspruch 7 angegeben gefertigt sind, wobei die als Spiegelflächen vorgesehenen Grundkörperflächen mit einem hochreflektierenden Material beschichtet sind.

11. Einrichtung nach Anspruch 9 oder 10, **dadurch gekennzeichnet, dass** die Spiegel (21,22), bevorzugt über Zwischenriegel (24,25), mit der Tragplatte (3) verbunden sind.

12. Einrichtung nach einem der Ansprüche 2 oder 6, **dadurch gekennzeichnet, dass** die elektrisch leitfähige Schicht (14) in Form mehrerer voneinander getrennter Segmente zwischen Grundkörper (13) und Isolierschicht (15) ausgebildet ist.

## Claims

1. Exposure system with a device for holding a substrate (18), **characterized by**:
- a table (1) which can be moved along the coordinates X, Y,
- an exposure optics (2) from which a corpuscular radiation is directed at right angles, in accordance with the coordinate Z, onto the substrate surface,
- a metering means for setting the distance between the table surface (5) and substrate (18), and for aligning the substrate (18) relative to the exposure optics,
- two support plates (3, 16) which are aligned parallel to the plane X, Y and are provided on the table (1) in the direction of the exposure optics (2) and are provided at different distances from the table surface (5), of which a first support plate (3) is directly connected to the table (1),
- the second support plate (16) being connected to the first support plate (3) via a holding apparatus with a holding function which can be switched off and on, and a bearing plane for the substrate (18) being formed on that side of the second support plate (16) which faces the exposure optics (2).

2. Device according to Claim 1, **characterized in that** provided as holding apparatus on the first support plate (3) is at least one electrostatic chuck arrangement (11) which has a basic body (13) fastened on the first support plate (3), an insulating layer (15) which forms the bearing plane for the second support plate (16), and an electrically conductive layer (14) arranged between the basic body (13) and the insulating layer (15).

3. Device according to Claim 2, **characterized in that** the at least one electrostatic chuck arrangement (11) is designed as a spacer by means of which both support plates (3, 16) are positioned at a prescribed distance from one another in the direction of the coordinate Z.

4. Device according to one of the preceding claims, **characterized in that** the first support plate (3) is connected to the table (1) via vibration-reducing elements (6).

5. Device according to one of the preceding claims, **characterized in that** the bearing plane, provided at the second support plate (16), for the substrate (18) is formed by three balls (17) placed in position in cages (19).

6. Device according to one of Claims 1 to 4, **characterized in that** provided on that surface of the second support plate (16) facing the exposure optics is at least one electrostatic chuck arrangement (23) which has a basic body (13) fastened on the support plate (16), an insulating layer (15) which forms the bearing plane for the substrate (18), and an electrically conductive layer (14) arranged between the basic body (13) and the insulating layer (15).

7. Device according to one of the preceding claims, **characterized in that** the second support plate (16), the basic bodies (13) and insulating layers (13) of the chuck arrangements (11, 23), and the balls (17) are produced from a glass ceramic having a coefficient of thermal expansion α_{τ}=0±0.05×10⁻⁶*K*⁻¹ and a modulus of elasticity of E≈90.6 GPa.

8. Device according to one of the preceding claims, **characterized in that** three cylindrically designed electrostatic chuck arrangements (11) are provided on the first support plate (3) and are arranged with radial symmetry on a divided circle.

9. Device according to one of the preceding claims, **characterized in that** two mirrors (21, 22) aligned orthogonally relative to one another are provided for determining and monitoring the position of the substrate with reference to the coordinates X, Y.

10. Device according to Claim 9, **characterized in that** the mirrors (21, 22) have basic bodies which are likewise produced from the glass ceramic as specified in Claim 7, the basic body surfaces provided as reflecting surfaces being coated with a highly reflecting material.

11. Device according to Claim 9 or 10, **characterized in that** the mirrors (21, 22) are preferably connected to the support plate (3) via intermediate bolts (24, 25).

12. Device according to one of Claims 2 or 6, **characterized in that** the electrically conductive layer (14) is designed in the form of a number of mutually separate segments between the basic body (13) and insulating layer (15).

## Revendications

1. Système d'exposition avec un dispositif pour soutenir un substrat (18), **caractérisé par** :
- une table (1) pouvant être déplacée selon les coordonnées X, Y,
- une optique d'exposition (2) à partir de laquelle un rayonnement corpusculaire est dirigé à angle droit, correspondant à la coordonnée Z, sur la surface du substrat,
- un moyen représentant un calibre pour ajuster la distance entre la surface de table (5) et le substrat (18) et pour orienter le substrat (18) par rapport à l'optique d'exposition,
- deux plaques supports (3, 16) orientées parallèlement au plan X, Y, qui sont prévues sur la table (1) dans la direction de l'optique d'exposition (2) et à différentes distances de la surface de table (5), parmi lesquelles une première plaque support (3) est reliée directement à la table (1), la deuxième plaque support (16) étant reliée à la première plaque support (3) par l'intermédiaire d'un dispositif de soutien avec une fonction de soutien pouvant être enclenchée ou interrompue, et un plan d'appui étant formé pour le substrat (18) sur le côté tourné vers l'optique d'exposition (2) de la deuxième plaque support (16).

2. Dispositif selon la revendication 1, **caractérisé en ce qu'**au moins une disposition de contention (11) électrostatique est prévue en tant que dispositif de soutien sur la première plaque support (3), qui présente un corps de base (13) fixé sur la première plaque support (3), une couche d'isolation (15) formant le plan d'appui pour la deuxième plaque support (16) et une couche électriquement conductrice (14) disposée entre le corps de base (13) et la couche d'isolation (15).

3. Dispositif selon la revendication 2, **caractérisé en ce que** ladite au moins une disposition de contention électrostatique (11) est formée en tant que pièce intercalaire, par le biais de laquelle les deux plaques supports (3, 16) sont positionnées l'une par rapport à l'autre, à une distance prédéterminée, dans la direction de la coordonnée Z.

4. Dispositif selon l'une quelconque des revendications précitées, **caractérisé en ce que** la première plaque support (3) est reliée à la table (1) par des éléments amortisseurs de vibrations (6).

5. Dispositif selon l'une quelconque des revendications précitées, **caractérisé en ce que** le plan d'appui prévu au niveau de la deuxième plaque support (16) pour le substrat (18) est formé par trois boules (17) fixées en position dans des cages (19).

6. Dispositif selon l'une quelconque des revendications 1 à 4, **caractérisé en ce que**, sur la surface tournée vers l'optique d'exposition de la deuxième plaque support (16), au moins une disposition de contention électrostatique (23) est prévue, qui présente un corps de base (13) fixé sur la plaque support (16), une couche d'isolation (15) formant le plan d'appui pour le substrat (18) et une couche électriquement conductrice (14) disposée entre le corps de base (13) et la couche d'isolation (15).

7. Dispositif selon l'une quelconque des revendications précitées, **caractérisé en ce que** la deuxième plaque support (16), le corps de base (13) et les couches d'isolation (15) des dispositions de contention (11, 23) et les boules (17) sont fabriqués en une vitrocéramique ayant un coefficient de dilatation en température de α_{T}=0±0, 05x10⁻⁶*K*⁻¹ et un module d'élasticité de E ≈ 90,6 GPa.

8. Dispositif selon l'une quelconque des revendications précitées, **caractérisé en ce que** trois dispositions de contention (11) électrostatiques réalisées sous forme de cylindres sont prévues sur la première plaque support (3) et disposées selon une symétrie radiale sur un cercle gradué.

9. Dispositif selon l'une quelconque des revendications précitées, **caractérisé en ce que** deux miroirs (21, 22) orientés orthogonalement l'un par rapport à l'autre sont prévus pour déterminer et contrôler la position du substrat par rapport aux coordonnées X, Y.

10. Dispositif selon la revendication 9, **caractérisé en ce que** les miroirs (21, 22) présentent des corps de base, qui sont également fabriqués en vitrocéramique, tel qu'indiqué selon la revendication 7, les surfaces de corps de base prévues en tant que surfaces de miroir, sont revêtues d'une matière très réfléchissante.

11. Dispositif selon la revendication 9 ou 10, **caractérisé en ce que** les miroirs (21, 22) sont reliés à la plaque support (3) de préférence par des entretoises (24, 25).

12. Dispositif selon l'une quelconque des revendications 2 ou 6, **caractérisé en ce que** la couche électriquement conductrice (14) est conçue sous la forme de plusieurs segments séparés l'un de l'autre entre le corps de base (13) et la couche d'isolation (15).
